# EUROPÄISCHE PATENTANMELDUNG

(11) **EP 1 179 841 A2**
(43) Veröffentlichungstag der Anmeldung: **13.02.2002**
(21) Anmeldenummer: 01114312.0
(22) Anmeldetag: 13.06.2001
(51) Int. Cl.: H01L 21/66

(54) **Verfahren und Vorrichtung zur Benutzerführung bei der optischen Vermessung von Schichten und Substraten und Software**

(30) Priorität: 07.07.2000 US 216688
(71) Anmelder: Leica Microsystems Jena GmbH, 07745 Jena (DE)
(72) Erfinder: Slodowski, Matthias, 7743 Jena (DE); Irmer, Karl-Heinz, 7747 Jena (DE)
(74) Vertreter: Reichert, Werner F., Dr.

(57) **Zusammenfassung**

Die Erfindung bezieht sich auf ein Verfahren, eine Vorrichtung und eine Software zur Benutzerführung bei der optischen Inspektion und Vermessung von beschichteten und unbeschichteten Substraten mit einem optischen Meßsystem, wobei ein integrierter Rezept- und Daten-Browser mit sortierbaren Merkmalen eingesetzt wird.

## Beschreibung

Die Erfindung bezieht sich auf ein Verfahren, eine Vorrichtung und eine Software zur Benutzerführung bei der optischen Inspektion und Vermessung von beschichteten und unbeschichteten Substraten.

In der Halbleiterindustrie werden zur Herstellung von integrierten Schaltkreisen eine Vielzahl von Prozessschritten benötigt, bei denen Strukturen auf Substrate, insbesondere auf Silizium-Wafer, durch verschiedene chemische und physikalische Prozesse aufgebracht werden. Dabei können Staubpartikel oder Defekte auf dem Substrat oder auf den Strukturen für das Gelingen der nächsten Prozessschritte oder für die spätere Funktion des integrierten Schaltkreises fatale Folgen haben. Dasselbe gilt auch für ungenaue Dicken oder ungenaue optische Parameter der auf dem Substrat aufgebrachten Schichten, durch die die Strukturen entstehen. Deshalb sind Geräte zur Erkennung von Staubpartikeln und Defekten und zur Messung von Schichtdicken für die Halbleiterherstellung unerlässlich. Hierfür sind besonders optische Systeme zur Inspektion, Defekterkennung und Schichtanalyse geeignet, da sie berührungslos und zerstörungsfrei arbeiten.

Optische Inspektions-, Defekt- und Schichtanalysesysteme sind aus dem Stand der Technik in vielfältiger Art und Weise bekannt und ihr Einsatz hat sich bei der Analyse von strukturierten und unstrukturierten Wafern bewährt.

Derartige optische Systeme werden insbesondere in der Produktionslinie der Halbleiterhersteller eingesetzt. Sie sind vollautomatisiert. Mittels Auszugsarmen entnehmen sie einer Waferkassette einen Wafer und transportieren ihn unter ein Mikroskop, um die Waferoberfläche mit entsprechender Vergrößerung zu untersuchenden. Die Staubpartikel und Defekte werden visuell oder per Video- oder CCD-Kamera erkannt und analysiert. Die auf dem Wafer aufgebrachten Schichten werden auf einem sehr kleinen Messspot vermessen und ihre optischen Materialeigenschaften und Dicken ermittelt. Mit Hilfe eines automatisch verfahrbaren Tisches können viele Punkte auf dem Wafer inspiziert und vermessen werden. Die entsprechenden Inspektions- und Messprogramme werden von dem Benutzer vorgegeben.

Bei Schichtanalysesystemen werden die optischen Materialeigenschaften (wie hauptsächlich der Brechungsindex n, Absorptionskoeffizient k, Reflektivität) der Substrate und der darauf aufgebrachten Schichten, deren Dicken und Schichtabfolge ermittelt. Diese meistens sehr dünnen Schichten bestehen aus verschiedenen Substanzen wie zum Beispiel Siliziumdioxid, Siliziumnitrid, Aluminium oder Lacke und ihre Dicken betragen von etwa 1 nm bis zu über 50 µm. Die optische Vermessung erfolgt mit Spektralphotometern und / oder Ellipsometern bzw. Spektralellipsometern. Hierbei wird der zu untersuchende Messort auf dem Wafer mit Licht verschiedener Wellenlängen, die vom Ultraviolett bis Infrarot betragen können, beleuchtet und das reflektierte Licht gemessen und analysiert.

Da bei der Waferherstellung immer dünnere Schichten und feinere Strukturen angestrebt werden, steigen entsprechend die Anforderungen an die Genauigkeit der optischen Meßsysteme, mit denen die Maßhaltigkeit der Schichten und Strukturen nachgewiesen werden kann. Neben der Forderung nach einer erhöhten Genauigkeit ist auch das Bestreben nach wachsenden Produktionsstückzahlen zu berücksichtigen. So ist es beispielsweise bei der kontinuierlichen Fertigung von Wafern erforderlich, diese in immer kürzer werdenden Abständen und möglichst online zu inspizieren und zu vermessen. Dabei kommt es auf eine benutzerfreundliche, leicht handhabbare Bedienung der optischen Meßsysteme an.

Der prinzipielle Bedienungsablauf besteht aus den Eingaben zur Erstellung eines Messrezeptes (Ablaufparameter, Ablaufprogramme, Messparameter), der Durchführung der Messungen und der Darstellung der Messergebnisse. Die Ablaufprogramme bestimmen zum Beispiel das Waferhandling, also welcher Wafer aus welcher Kassette entnommen wird und an welchen Koordinatenpunkten der Wafer untersucht werden soll. Das Alignment des Wafers, bei dem der Wafer gegenüber dem Koordinatensystem des optischen Messsystems ausgerichtet wird, das Ablegen des Wafers auf einen motorisierten Tisch und das Verfahren des Wafers unter dem Mikroskop laufen im allgemeinen vollautomatisch ab.

Bisherige optische Inspektions- und Meßsysteme zeigen beispielsweise ein oder mehrere Fenster auf einem Computerbildschirm, in denen die einzustellenden Ablauf- und Messparameter oder Ablauf- und Messprogramme als Stichworte untereinander aufgelistet sind. Am linken Rand der Stichwortliste befindet sich ein als Pfeil ausgebildetes Symbol, das mittels der Cursortasten der Computer-Tastatur in vertikaler Richtung bewegt und dabei an den Stichworten vorbeigeführt werden kann. Wird auf dieser Art und Weise der Pfeil auf ein Stichwort positioniert, das einen Parameterwert angibt, so kann der Parameterwert eingegeben werden. Bedeutet das Stichwort ein Ablauf- oder Messprogramm, so wird dieses durch Drücken der Returntaste ausgeführt. Zum Aufruf des vorherigen Fensters oder eines anderen Fensters wird der Pfeil an die entsprechende Position gebracht und die Returntaste gedrückt. Zusätzlich können die Funktionstasten der Computer-Tastatur für Hilfsfunktionen verwendet werden. Diese Prozeduren der Menüführung für die Eingabe von Messparametern und die Ausführung und Ergebnisdarstellung von Messprogrammen ist zeitaufwendig und nicht sehr übersichtlich.

Es ist die Aufgabe der Erfindung, eine Benutzerführung bei der optischen Inspektion und Defekterkennung auf Oberflächen von Substraten und / oder von darauf aufgebrachten Schichten und bei der optischen Vermessung von Substraten und von auf den Substraten aufgebrachten Schichten mit einem Schichtanalysesystem anzugeben, die einfach, übersichtlich, schnell und leicht erlernbar ist.

Diese Aufgabe wird mit einem integrierten Rezept- und Daten-Browser gelöst. Weitere Ausgestaltungen finden sich in den Merkmalen der Unteransprüche. Zudem sind interaktive Research-Messungen auch während einer Rezepterstellung durchführbar. Dabei können die gefundenen Einstellwerte bei einer optimalen Messung in das aktuelle Rezept übernommen werden.

Der integrierte Rezept- und Daten-Browser dient der Erstellung der Geräteeinstellungen und der gleichzeitigen Darstellung von Daten. Das Wort "integriert" soll die Gleichzeitigkeit der Darstellung des Rezept- und Daten-Browsers auf dem Bildschirm und den Zugriff auf beide Browser zum Ausdruck bringen. Die Aufteilung von Rezept- und Daten-Browser auf dem Bildschirm kann prinzipiell beliebig vorgenommen werden. Vorzugsweise ist der Daten-Browser in einem Bildschirmbereich unterhalb des Rezept-Browsers angeordnet. Diese Anordnung der Browser ist für alle Grund-Bedienhandlungen, nämlich Messrezept erstellen, Messungen durchführen, Ergebnisse betrachten und auch Wiederauffinden bereits durchgeführter oder früherer Messungen, gleich und somit leicht einprägsam, leicht handhabbar und sehr komfortabel für den Benutzer.

Die Rezepterstellung wird durch den Benutzer vorgenommen und bedeutet unter anderem die Auswahl von Ablauf- und Messprogrammen, die Eingabe von Messparametern wie z.B. die Wahl des Objektivs, der Beleuchtung, gegebenenfalls der Fokuseinstellung, Kameraeinstellung etc., aber auch Eingaben wie die Messwerte abgespeichert werden, ob sie untereinander verglichen werden oder welche Auswertemethode gewählt wird. Auch Informationsdaten können eingegeben werden, wie z.B. die Los-Nummer der Wafer oder deren Durchmesser oder wer der Bedieningenieur ist und ähnliches. Da ein Rezept quasi als Job anzusehen ist, wird der Rezept-Browser auch als Job-Browser bezeichnet, wie es weiter unten und in den Figuren der Fall ist.

Liegen aus vorhergehenden Messungen bereits Datensätze vor, so können diese im Daten-Browser angesehen werden, nachdem sie im Rezept-Browser entsprechend aufgerufen wurden.

Zur weiteren Erleichterung beim Abspeichern oder Auffinden von Datensätzen können zusätzlich in einem weiteren Feld auf dem Bildschirm die Verzeichnisse und Unterverzeichnisse in der von "Windows" bekannten Baumstruktur gezeigt werden. Vorzugsweise wird der "Directory Tree" in der linken Hälfte des Bildschirms angezeigt. Der Benutzer kann somit direkt die in einem Unterverzeichnis abgespeicherten Rezept- und Datensätze aufrufen bzw. erzeugte Rezept- und Datensätze in vorhandene oder neu generierte Unterverzeichnisse abspeichern.

Somit ist also der gesamte Browser - im folgenden einfach als Browser bezeichnet - in drei Bereiche aufgeteilt:
- Bereich links: "Directories", Baumstruktur der in selbst erzeugbaren Verzeichnissen gespeicherten Jobs
- Bereich rechts oben: "Jobs of selcted directory", zeigt die Jobs des gewählten Verzeichnisses
- Bereich rechts unten: "Data of selected jobs" oder äquivalent "Measurements of selected jobs", zeigt die Messungen des gewählten Jobs

Die Bereiche sind durch den Bediener frei skalierbar.

In den Bereichen "Jobs of selcted directory" und "Measurements of selected jobs" kann man die Einträge (Zeilen) nach bestimmten Kriterien (Spalten) ordnen. Spalten des Job-Bereiches sind beispielsweise: Name, Eigner, Scantyp, Layer Stack, Erzeugungsdatum, letzte Änderung etc. Klickt man eine Spaltenüberschrift, werden die Inhalte geordnet.

Die Vorteile des Browsers liegen einerseits in der leichten Auswahl von Jobs durch Browsen in verschiedenen Inhaltskatgorien, nach denen auch geordnet werden kann. Bei einigen hundert Jobs (Meßrezepten), die in einer Halbleiter-Fabrik erzeugt werden, ist das sowohl für den Operator als auch für den Engineer eine deutliche Erleichterung und Zeitersparnis.

Zusätzlich wird die Auswahl von Jobs erleichtert und es ist eine schnelle Datenübersicht durch den zu jedem Job angezeigten Bereich "Measurements of selected job" möglich. Hier sind die Mittelwerte aller mit diesem Job gemessenen Daten aufgelistet. Jobs können anhand dieser Daten fehlersicherer ausgewählt werden, da die Vorgeschichte des Jobs eingesehen werden kann. Eine Bewertung des aktuellen Meßergebnisses auch in Beziehung zu früher gemessenen Daten ist sofort ohne Umwege möglich.

Der Job-Browser startet als Mainscreen nach dem Hochfahren der Software. Ganz oben am Bildschirm ist eine Toolbar-Leiste angeordnet. Mit der Back-Taste links in der Toolbar-Leiste, die, gelangt man stets zum Mainscreen.

Neben dem Job-Browser gibt es als Hauptmodule der Software aus Anwendersicht noch den Job-Commander zum Erzeugen und Editieren von Mess- und Auswerterezepten (mit Back zurück zum Browser) und den Data-Commander zum Auswerten von Datendetails, Generieren von Graphiken usw.

Der Job-Commader dient der Erzeugung und Editierung von Mess- und Auswerterezepten und ist das Hauptarbeitswerkzeug für den Engineer. Die Hauptinhalte eines Rezeptes sind auf Tab-Karten ("Register-Karten) gegliedert. Eine der Tab-Karten, die Page "Application", enthält einen Bereich "Research". Über den Toolbar-Button "Measure" kann von jeder Stelle des Job-Commanders aus eine Messung an der aktuellen Position mit den aktuellen Einstellungen ausgeführt werden. Die Ergebnisse werden mit allen wichtigen Informationen (u.a. mit dem Messspektrum) im Bereich "research" angezeigt. Mehrere solcher Messungen können in einem Research-File abgespeichert und später wieder geladen werden. Beim Browsen durch Research-Messungen werden die dort gespeicherten Einstellungen übernommen. Die beste Einstellung kann in das aktuelle Rezept übernommen werden.

Die Vorteile des Job-Commanders sind die Gliederung in Tab-Pages und die interaktiven, speicherbaren und übernehmbaren Research-Messungen von jeder Stelle des Job-Commanders aus. Damit kann der Engineer interaktiv die für die jeweilige Applikation besten Einstellungen des Systems komfortabel ermitteln. Sie können zudem für spätere Wiederholungsmessungen oder für die Arbeit des Operators in der Fertigungslinie gespeichert und übernommen werden.

Der Data-Commander ist ähnlich dem Browser in mehrere Bereiche geteilt, die ebenso durch den Bediener frei skalierbar sind. In einem oberen Bereich "Measurements of job: *name"* stehen die gleichen Inhalte, wie im unteren Bereich des Browsers, nämlich die Mittelwerte der Wafer-Messungen des Jobs. Im unteren Bereich stehen die Meßpunkte zu der im oberen Bereich ausgewählten Wafer-Messung. Am rechten Rand des Screens sind die für den jeweiligen Bereich geltenden Bedienelemente angeordnet.

Die Vorteile des Data-Commanders sind das gleiche "look and feel" wie beim Browser und die Statistikangaben unter jeder Spalte.

Somit sind der Browser, der Job-Commander und der Data-Commander auf optimale Benutzerfreundlichkeit, auf leichte und schnelle Bedienbarkeit für komplexe optische Inspektions- und Messgeräte insbesondere für die Halbleiterindustrie ausgerichtet. Neben der einfachen Erstellung von Messrezepten und der übersichtlichen Darstellung von Messergebnissen sind die Module durch ihre hohe Flexibilität auch zur schnellen Anpassung an sich verändernde Anforderungen geeignet.

Die Erfindung wird nachfolgend anhand eines in der Zeichnung dargestellten Ausführungsbeispiels näher erläutert. Die Zeichnung zeigt in:
- Fig.1: schematisch einen integrierten Rezept- und Daten-Browser und einen Verzeichnisbaum,
- Fig.2: schematisch den Ablauf für eine Rezepterstellung,
- Fig.3: schematisch eine Abfolge bei einem Inspektions- oder Messdurchlauf,
- Fig.4: schematisch Details des Browsers bei einem Messdurchlauf,
- Fig.5: schematisch eine Abfolge mit dem Data-Commander zum Darstellen von Inspektions- und Messergebnissen,
- Fig.6: schematisch Beispiele für die Inhalte des Rezept- und Daten-Browsers und der Verbindungen nach außen,
- Fig.7: schematisch einen Überblick über die Zusammenhänge des Rezept- und Daten-Browsers ("Job Browser") mit anderen Browsern und Programmen,
- Fig.8: schematisch die Benutzung zweier Mess-Anwendungen,
- Fig.9: ein Bild eines optischen Meßsystems mit einem Bildschirm für den erfindungsgemäßen Browser,
- Fig.10 bis 16: schematisch Details zum Job-Commander,
- Fig.17 und 18: schematisch Details für einen Inspektions- oder Messdurchlauf ("Run"),
- Fig.19 bis 21: schematisch Details zum Data-Commander,
- Fig.22: schematisch den Browser für Batch-Jobs und
- Fig.23: ein Beispiel aus dem Stand der Technik.

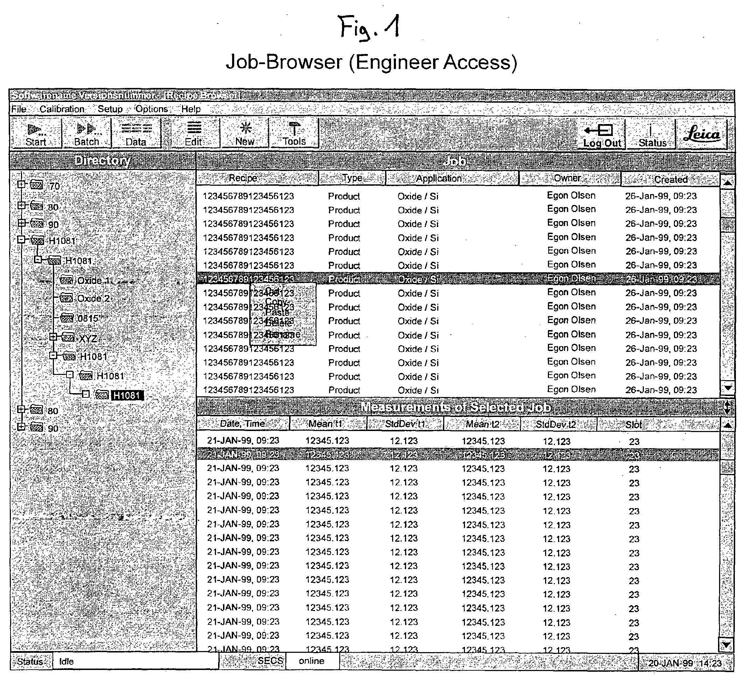

Fig.1 zeigt in einem Ausgangsfenster (Mainscreen) den erfindungsgemäßen integrierten Rezept- und Daten-Browser unter "JOB" in einem oberen und unter "Measuerments of selected Jobs" in einem unteren Feld des Bildschirms. Im Rezept-Browser sind in den einzelnen Zeilen die Jobs des gerade ausgewählten Directories zu sehen. Es kann eine Zeile ausgewählt werden und entsprechend der markierten Zeile des Rezept-Browsers erscheinen zugleich die zugehörigen Daten im Daten-Browser. Durch Browsen durch den Rezept-Browser erscheinen alle Jobs des ausgewählten Directorys jeweils in Form einer zeilenweisen Information (Rezept-/Job-nummer, Jobtyp etc.) im Rezept-Browser. In analoger Weise können die zu einer ausgewählten Zeile des Rezept-Browsers gehörenden Daten im Daten-Browser ebenfalls durch Browsen durchgesehen werden. In beiden Browsern können die Inhalte nach verschiedenen Kriterien geordnet werden, z.B. nach der Job-nummer, nach dem Produkt, dem Besitzer, dem Erstelldatum usw. Die Ansichtsbereiche der Browser sind durch den Benutzer frei einstellbar.

Im linken Bereich des Bildschirms ist zeitgleich der Verzeichnisbaum ("Directory Tree") mit dem aktuell geöffneten Verzeichnis zu sehen. Die einzelnen Verzeichnisse können durch Anklicken geöffnet werden und es erscheinen die entsprechenden Informationen im Rezept- und Daten-Browser. Auch das Feld des Verzeichnisbaums ist frei einstellbar. Die Bildschirminhalte sind mit einem graphical user interface (GUI) erstellt und aufgebaut.

Am oberen Rand des Bildschirms ist eine Toolbar-Leiste installiert, mit der unter anderem die Rezept- und Daten-Browser editiert werden können.

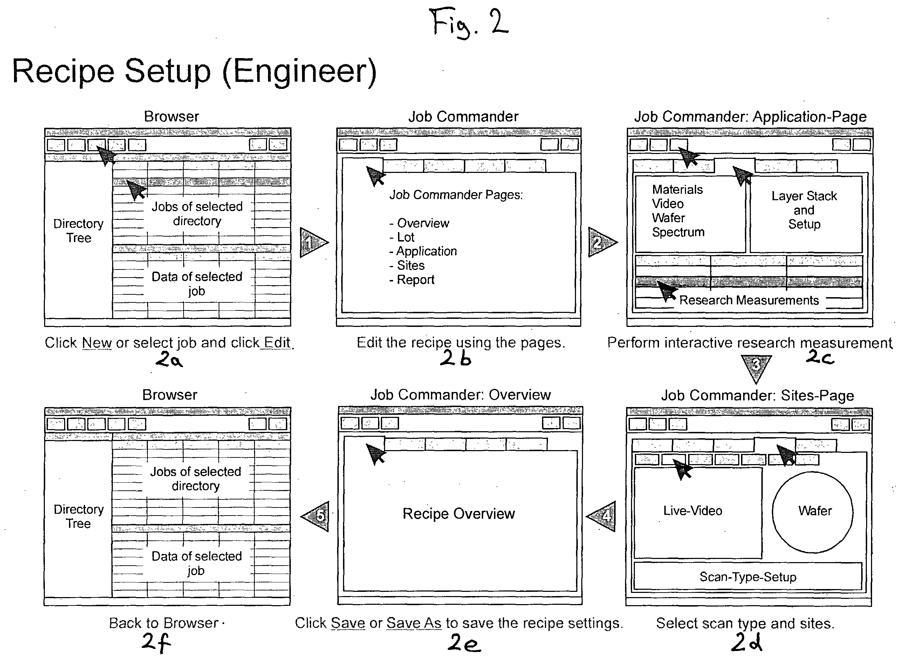

In Fig. 2 ist ein Beispiel für den Ablauf einer Rezepterstellung gezeigt. Die erfindungsgemäßen integrierten Rezept- und Daten-Browser in Fig.2a sind als "Jobs of selected directory" und "Data of selected jobs" in einem oberen und unteren Feld des Bildschirms eingezeichnet. In einem linken Feld befindet sich der Verzeichnisbaum ("Directory Tree"). Durch Anklicken des Buttons "New" bzw. "Edit" in der Toolbar-Leiste kann ein neuer Job erstellt bzw. ein im Rezept-Browser markierter Job zur Veränderung seines Inhalts aufgerufen werden. Es erscheint der Job-Commander mit Registerkarten, wie in Fig. 2b zu sehen ist. Die Inhalte eines Rezepts werden in den entsprechenden Registerkarten eingetragen bzw. geändert. Beispielsweise können auf der Registerkarte "Application" gemäß Fig.2c Materialdaten, Videoparameter, Waferdaten und Daten über Spektren oder den Aufbau von Schichten aufgenommen werden. Durch Betätigen des Buttons "Measurement" in der Toolbar-Leiste werden eine oder mehrere Messungen mit den eingestellten Parametern durchgeführt und die Messergebnisse in einem unteren Feld auf dem Bildschirm angezeigt ("Research Measurements").

Auf der Registerkarte "Sites" in Fig. 2d ist die Messposition auf dem Wafer grafisch dargestellt. Ein Fadenkreuz auf dem Wafer zeigt die Messposition an. An dieser Messposition wird die Waferoberfläche mit einer Videokamera aufgenommen und das Videobild in einem linken Feld des Bildschirmes live gezeigt. Die nicht dargestellte Optik (Mikroskop) des optischen Meßsystems liefert zusammen mit der Videokamera ein entsprechend vergrößertes Live-Bild. Oberhalb des Videobildes ist eine Button-Leiste dargestellt, mit der verschiedene Scan-Arten gewählt werden können. Z.B. können einzelne oder mehrere definierter Punkte auf dem Wafer angefahren und untersucht werden. Oder es werden einzelne Zeilen auf dem Wafer oder der gesamte Wafer gescannt. Es ist möglich, direkt von dieser Registerkarte "Sites" gemäß der eingestellten Scan-Art einen Messablauf zu starten und durchzuführen. Selbstverständlich kann auch direkt an dem aktuellen Ort auf dem Wafer, der mit dem Fadenkreuz markiert ist und von dem ein Live-Videobild gezeigt wird, eine Messung, beispielsweise eine Schichtdickenmessung, vorgenommen und die Ergebnisse sofort angezeigt werden.

Um gegebenenfalls die Messergebnisse weiter zu verbessern, können die Einstellparameter verändert werden. Diese Veränderungen können manuell oder automatisch vorgenommen werden. Auf diese Weise kann der Benutzer gezielt oder auch durch Ausprobieren zu optimalen Messergebnissen gelangen. Die Erfahrung des Benutzers oder bestimmte Kennwerten über die Güte der Auswertung oder auch direkte, vom Meßsystems automatisch gelieferte Angaben über die Güte der Auswertung (z.B. Fit) entscheiden darüber, ob ein Messergebnis optimal ist. Die Einstellparameter bei den verschiedenen Messergebnissen und insbesondere bei einem erzielten optimalen Messergebnis können für das aktuelle Rezept übernommen werden. Damit ist eine interaktive, speicherbare Research-Messung während einer Rezepterstellung durchführbar, bei der bei Bedarf sogar eine Übernahme der aktuellen Einstellwerte in das aktuelle Rezept möglich ist.

Die Registerkarte in Fig. 2e zeigt einen Überblick über alle derart erstellten Rezepte mit den jeweiligen vorgenommenen Einstellungen. Es können alle Rezepte oder ein Teile davon inklusive der zugehörigen Messergebnisse abgespeichert werden.

Durch einen Klick auf den Button "back" der Toolbar-Leiste erscheint wieder der Ausgangsbildschirm "Browser" (Fig. 2f).

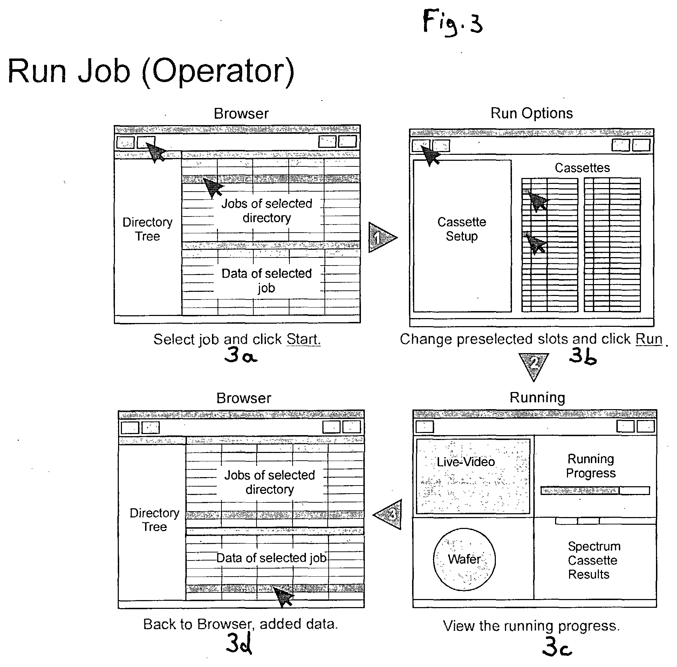

Fig. 3 zeigt beispielhaft eine Abfolge bei einem Job-Lauf in der Fertigungslinie. Der Ausgangsbildschirm ist ebenfalls der Browser mit den bereits beschriebenen Aufteilungen in Rezept- und Daten-Browser und den Directory Tree (Fig. 3a). Der Operator wählt zunächst Optionen für den Inspektions-bzw. Messdurchgang aus, wie z.B. welche Wafer aus welcher Kassette genommen werden sollen (Fig.3 b). Während des Messdurchganges werden die aktuelle Messposition auf dem Wafer, das zugehörige Videobild und eine Information über den bereits abgearbeiteten Umfang (in %) des Messdurchganges auf dem Bildschirm angezeigt (Fig.3c). Damit kann der Messdurchlauf beobachtet oder überwacht werden. Nach Beendigung des Durchlaufes erscheint wieder der Browser mit den neu hinzugekommenen Daten (Fig.3d).

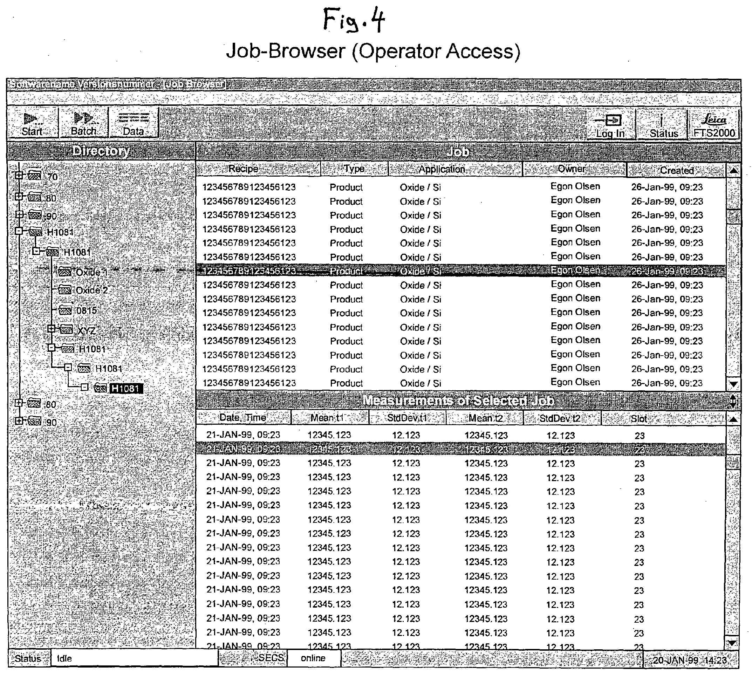

Fig. 4 zeigt Details des Browsers bei einem Messdurchlauf.

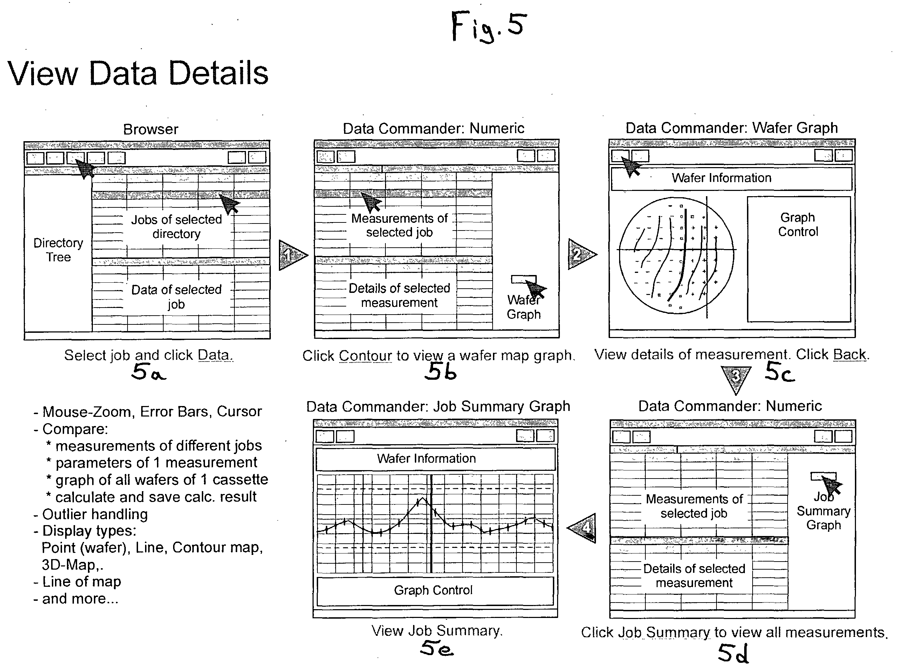

Zum Betrachten der erzeugten Daten - oder auch älterer Daten - wird gemäß dem Ablauf in Fig. 5 im Browser der gewünschte Job ausgewählt und durch Klicken auf den Button "Data" (Fig.5a) der Data-Commander aktiviert (Fig. 5b). Die Daten werden numerisch angezeigt. Sie können bei Bedarf unterschiedlich sortiert werden. Die Daten können auch graphisch dargestellt werden, wie Fig. 5c zeigt. Hier sind am Beispiel einer Schichtdickenmessung über den gesamten Wafer die gemessenen Stellen auf dem Wafer und die zugehörigen Schichtdicken durch unterschiedliche Zeichen angezeigt. Zudem werden die Höhenlinien, also die Linien gleicher Schichtdicke, dargestellt. Im Menü "Graph Control" können verschiedene Parameter für die Graphikdarstellung eingestellt werden.

Durch Betätigen eines Buttons "Job Summary Graph" (Fig.5d) können auch Messergebnisse über die Zeit dargestellt werden. Dies ist vor allem wichtig, um Veränderungen im Produktionsprozess zu erkennen. So werden z.B. bei den Produktionsdurchläufen auf jedem Wafer jeweils an einer bestimmten Ortskoordinate Messungen automatisch vorgenommen und abgespeichert. Auf diese Weise können über bestimmte Zeiträume (Stunden, Tage oder Wochen) aus dem Verlauf der Messungen Rückschlüsse auf den Produktionsprozess gezogen werden. In Fig. 5e ist ein solcher Messwertverlauf, z.B. Veränderungen in der Schichtdicke, als Funktion der Zeit dargestellt.

Es können aber eine Vielzahl weiterer informativer graphischer Darstellungen gezeigt werden, die in Fig. 5 links unten stichwortartig aufgeführt sind.

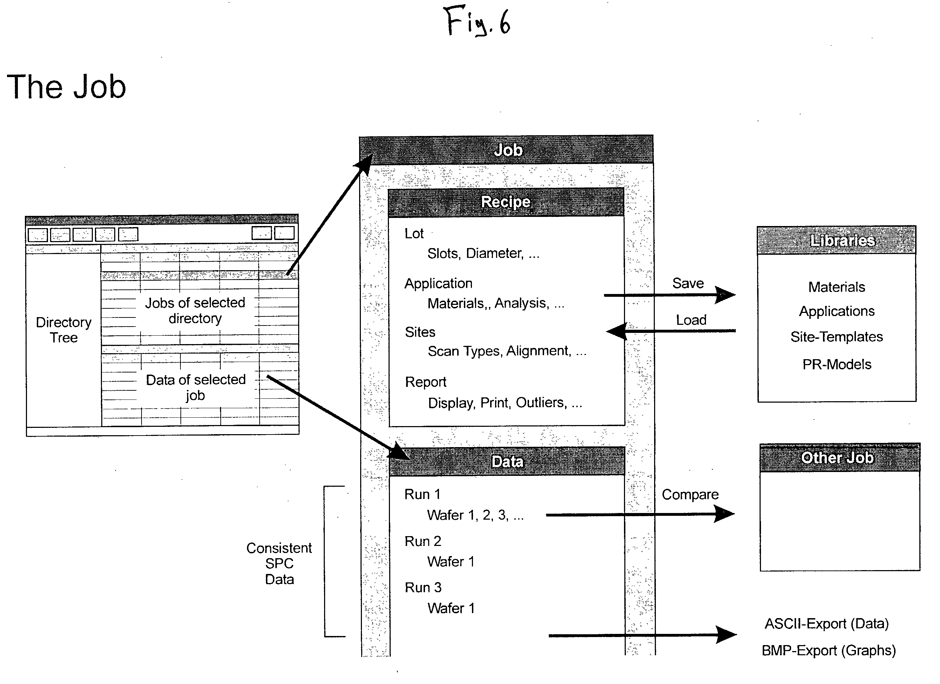

Fig. 6 zeigt in einem Überblick den Browser als Ausgangsbildschirm mit den Zugriffen auf einige wichtige Einstellparameter des Rezept-Browsers und deren Austausch mit Bibliotheken und auch auf die Daten des Daten-Browsers, dessen Daten untereinander oder mit älteren Daten ("Other Jobs) mittels eines SPC (Statistic Process Control) verglichen werden können. Die Daten können auch per ASCII-Code oder im Bit-map-Format zur Verarbeitung mit anderen Programmen exportiert werden.

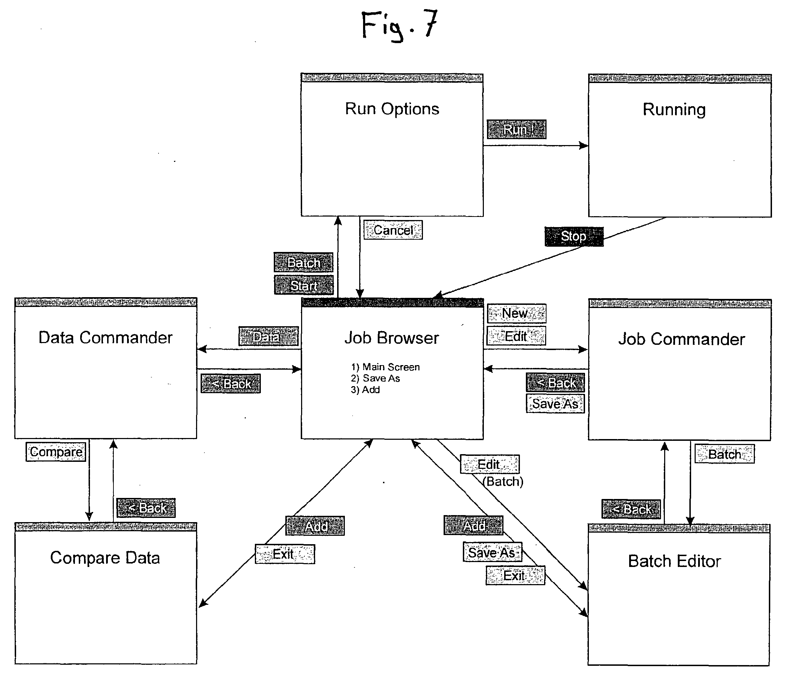

Fig. 7 zeigt in einer Übersicht die Zusammenhänge des Rezept- und Daten-Browsers ("Job Browser") mit verschiedenen Modulen, insbesondere mit dem Job-Commander, dem Data-Commander und dem Modul Messdurchlauf ("Run options", "Running").

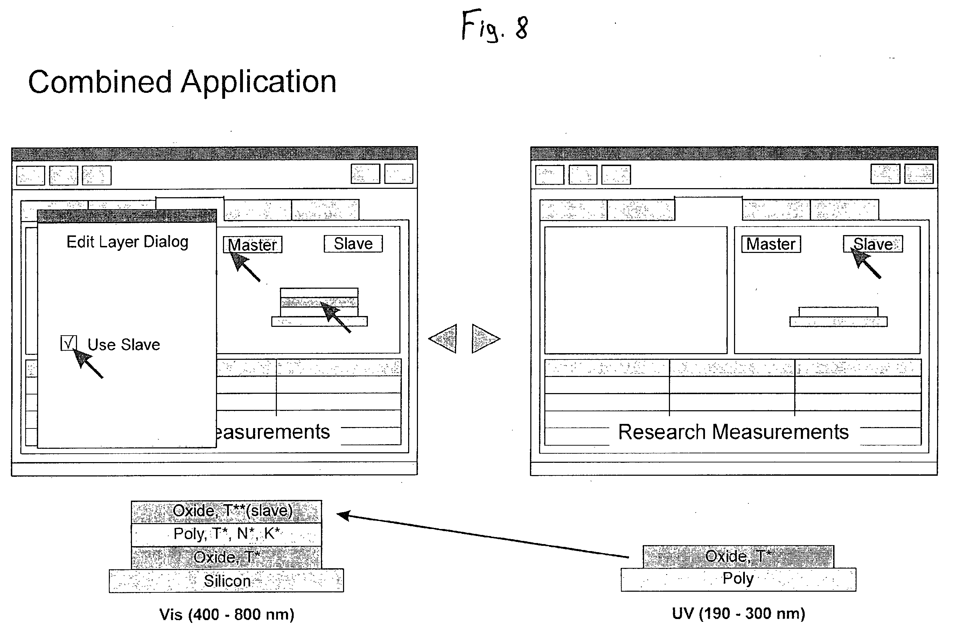

Fig. 8 zeigt ein Beispiel für eine spezielle Messanwendung bei der Schichtdickenmessung. Mit einer Master- und einer Slave-Einstellung können zwei verschiedene Messarten miteinander kombiniert werden. Diese Messarten sind beispielsweise die Verwendung von zwei verschiedenen Wellenlängenbereichen für die optische Messung oder die Verwendung zweier verschiedener Messmethoden wie der Spektralphotometrie und der Ellipsometrie bzw. Spektralellipsometrie. Die beiden Messarten werden miteinander in der Art kombiniert, dass das Messergebnis der einen Messart als Vorinformation dient und in die Messung in der anderen Messart mit einfließt. So kann beispielsweise einen Layer stack von drei Schichten auf einem Siliziumwafer (Fig. 8) zunächst im UV-Bereich gemessen werden. Da die mittlere Schicht aus UV-undurchlässigem Polysilizium besteht, wird nur die oberste Schicht vermessen und die Schichtdicke und gegebenenfalls weitere optische Parameter bestimmt. Dieses Messergebnis wird für die Messung im sichtbaren Wellenlängenbereich genutzt, für den das Polysilizium durchlässig ist und somit alle Schichten vermessen werden können.

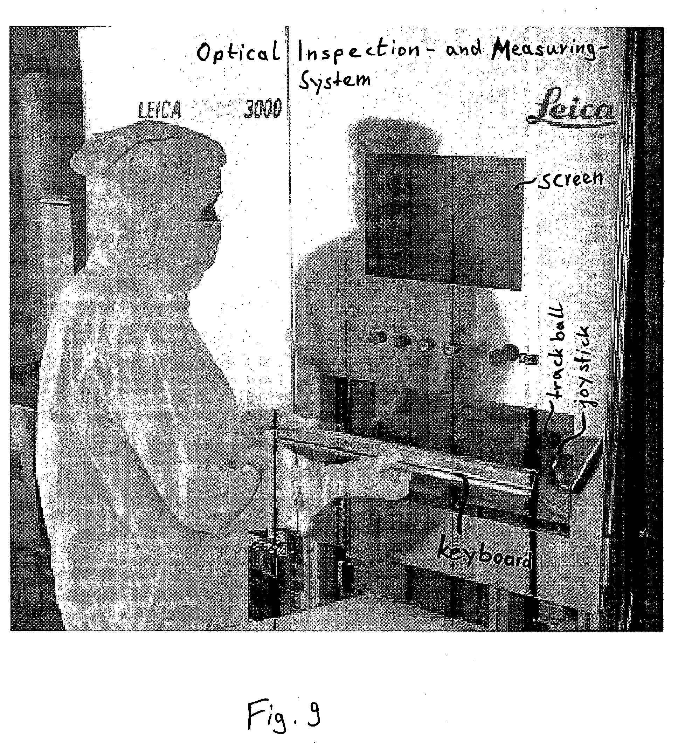

In Fig. 9 ist in einer Gesamtansicht als Beispiel für ein optisches Meßsystem ein Schichtanalysesystem zu sehen. Etwa in der Mitte des Meßsystems ist ein Bildschirm erkennbar, auf dem die in den anderen Figuren gezeigten Fenster erscheinen. Ein Benutzer kann das Meßsystem über Eingaben auf einer Tastatur, einem Joystick oder einer Maus bzw. Trackball bedienen.

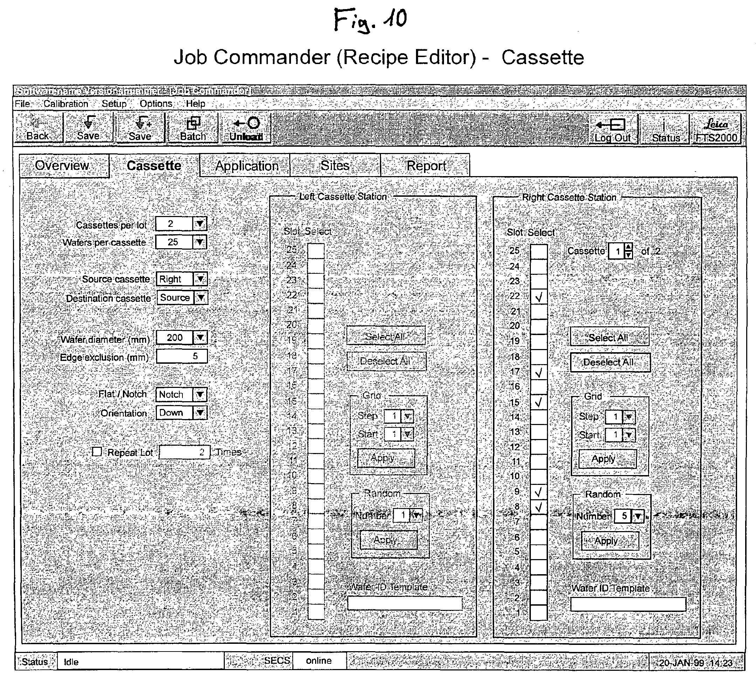

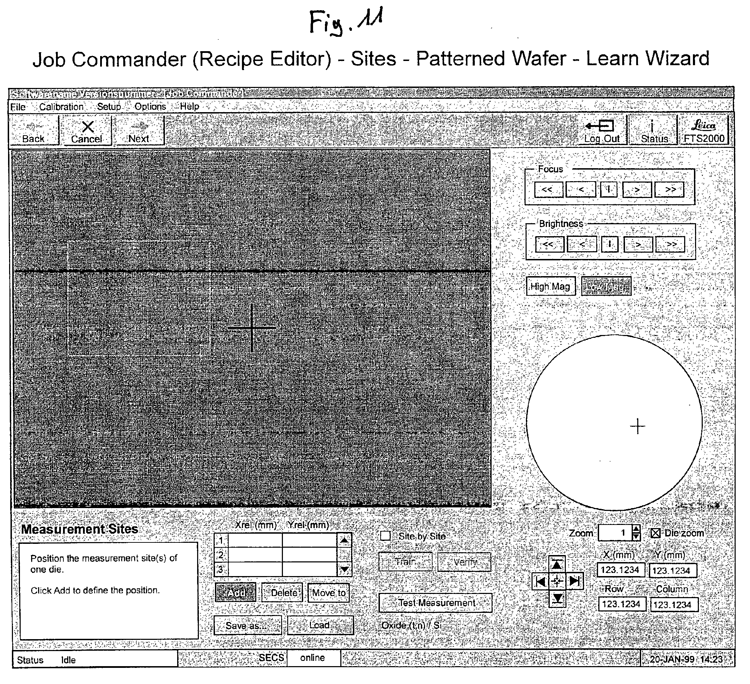

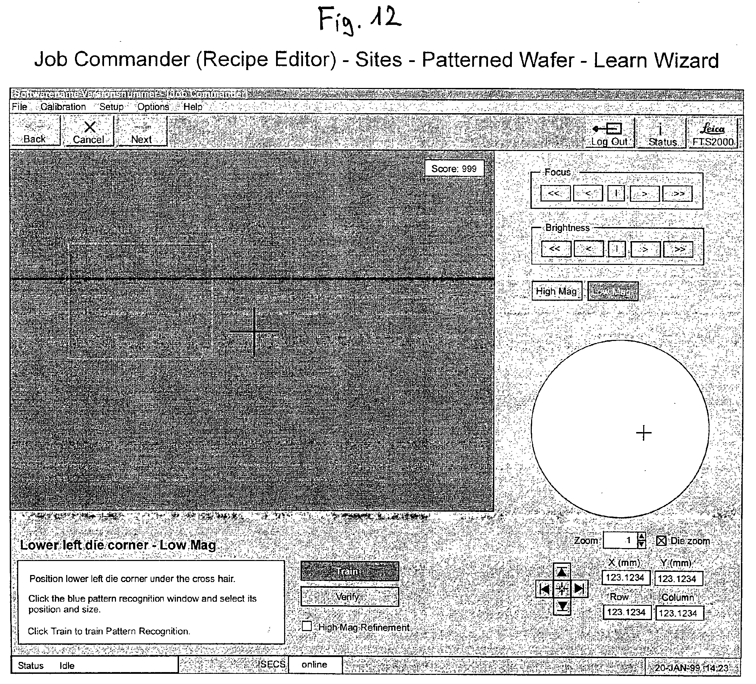

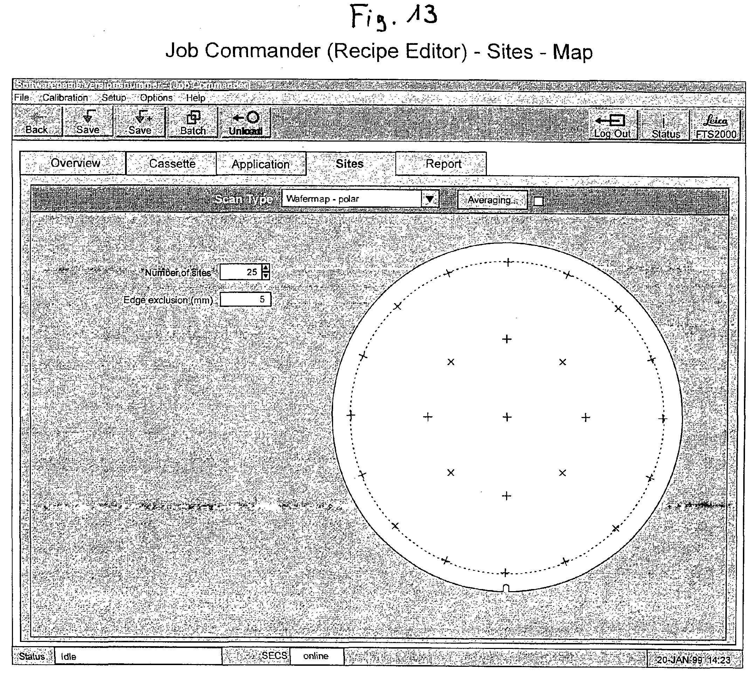

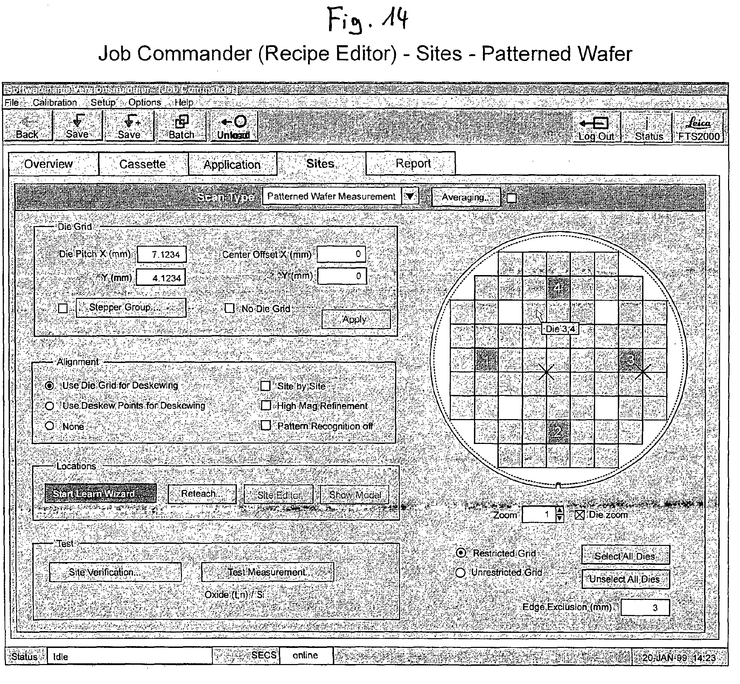

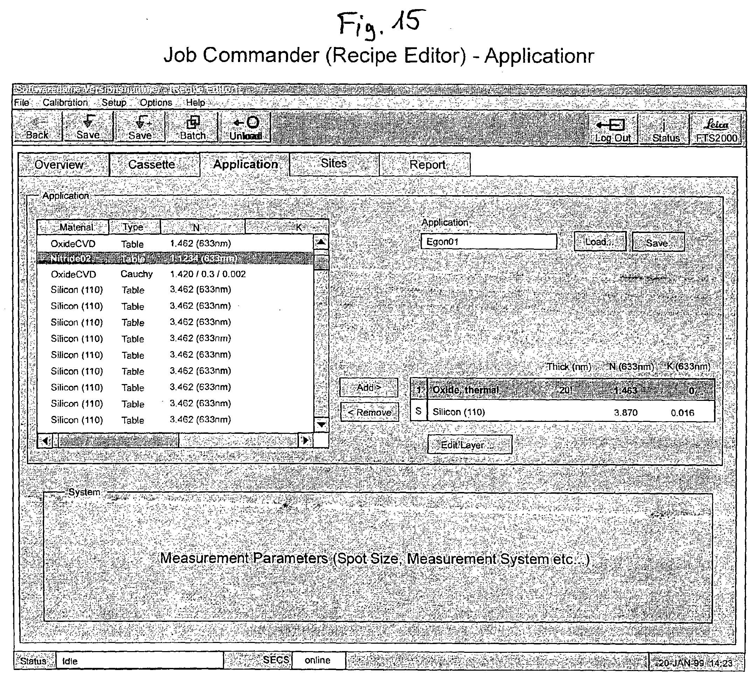

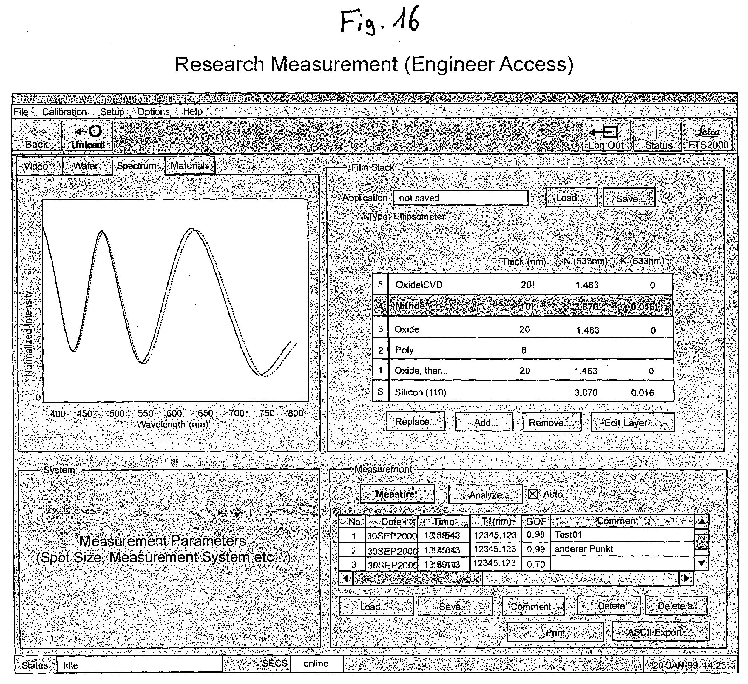

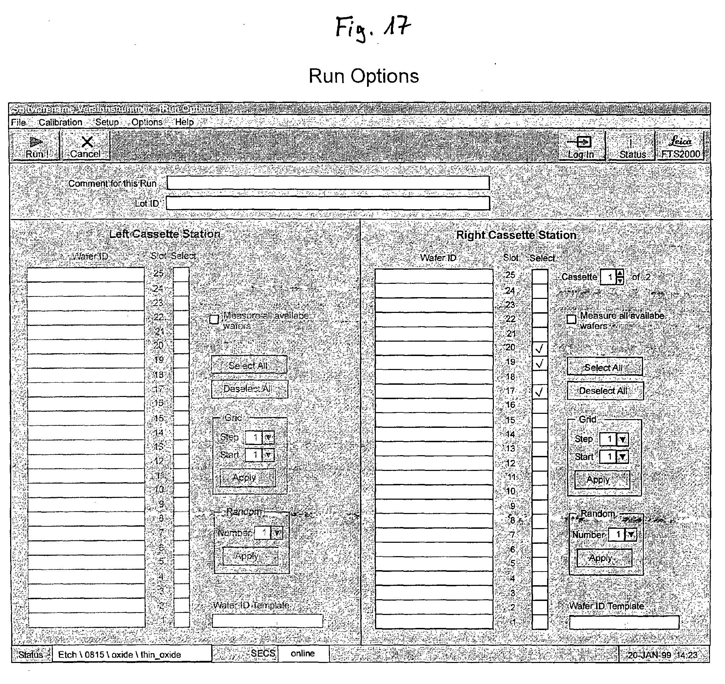

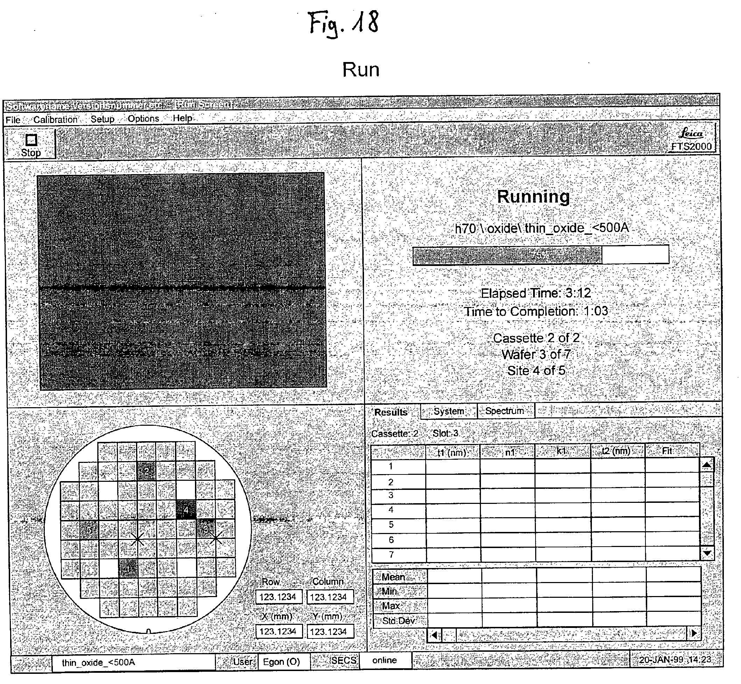

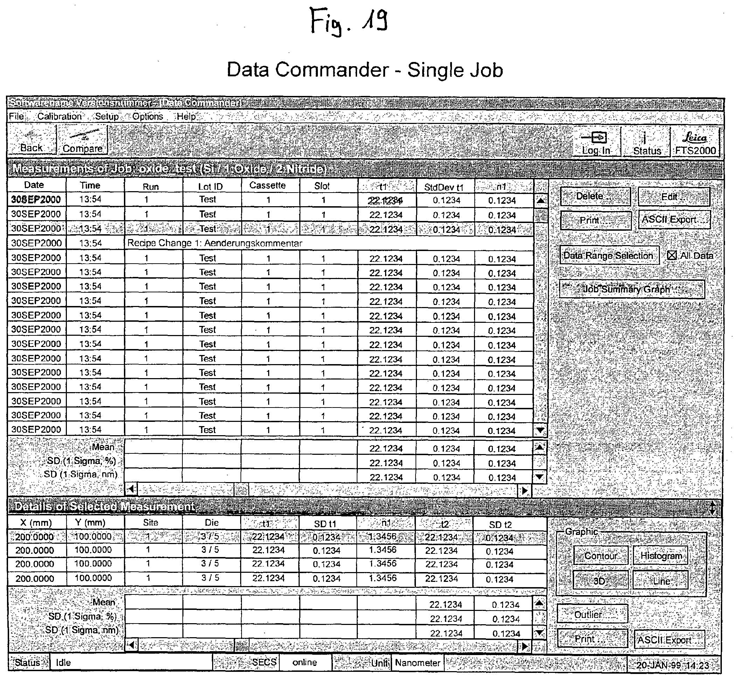

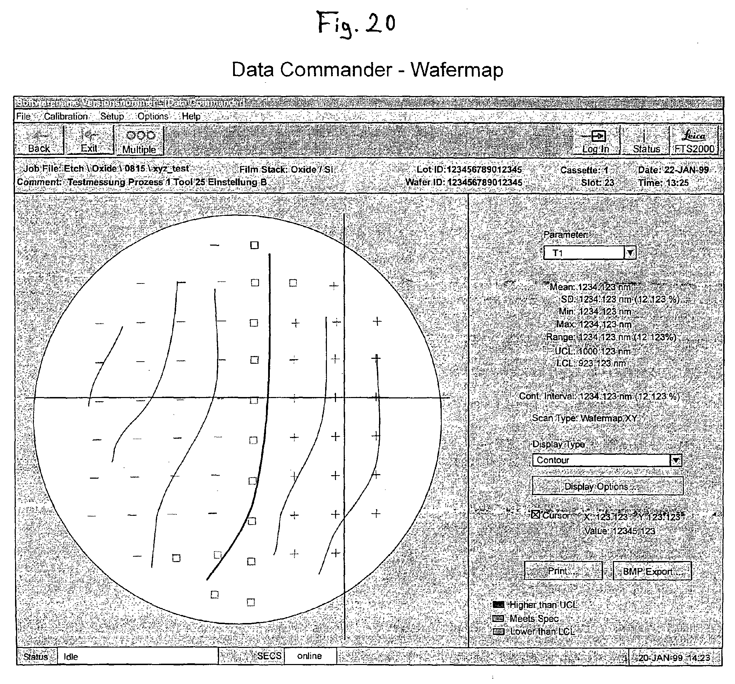

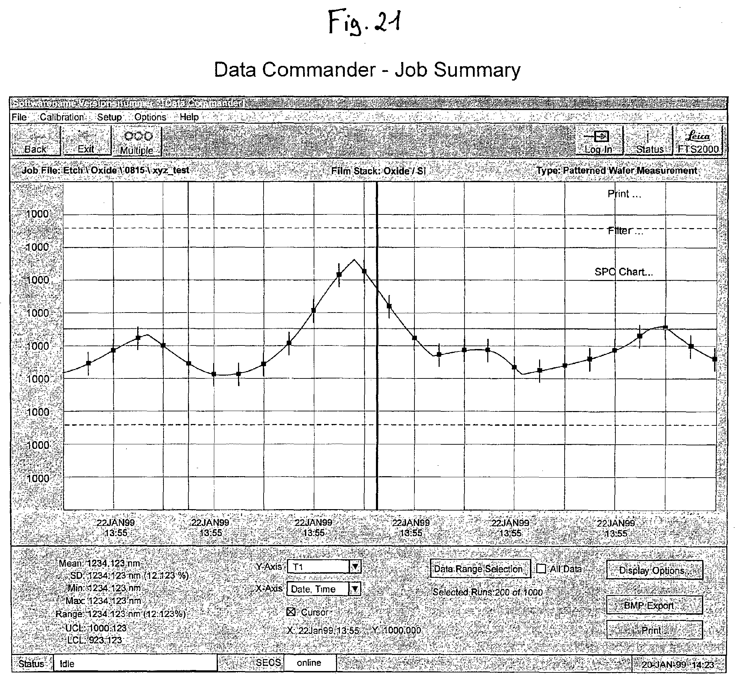

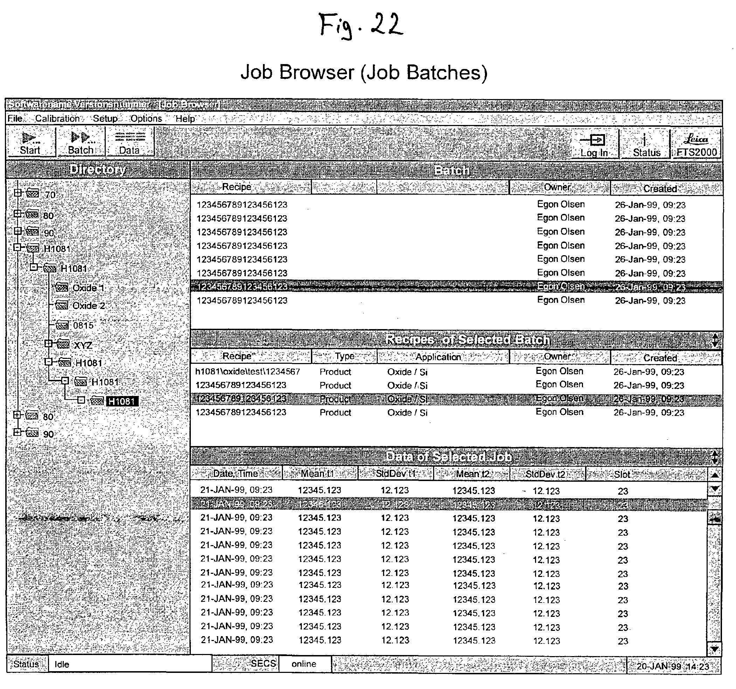

Die Fig. 10 bis 22 sind aufgrund ihrer Beschriftung und im Kontext der obigen Erläuterungen selbsterklärend. Die Fig. 10 bis 16 geben Details des Job-Commanders wider. Details für den Messlauf ("Run") werden in den Fig. 17 und 18, für den Data-Commander in den Fig. 19 bis 21 und für Batch-Jobs in Fig. 22 beschrieben.

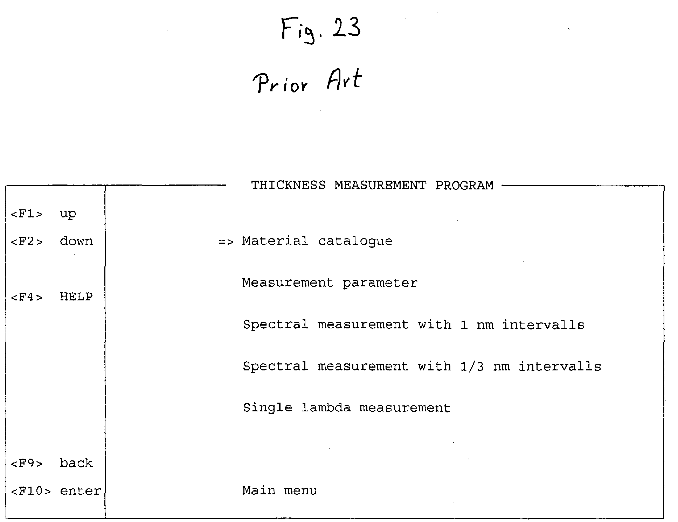

Fig. 23 zeigt als Beispiel für den Stand der Technik eine Bildschirmmaske, in der ein Pfeil mittels der Cursortasten einer Tastatur auf und ab bewegt werden kann. Zeigt der Pfeil auf einen bestimmten Menuepunkt (Stichwort), so wird das entsprechende Programm ausgeführt bzw. zu der zugehörigen Bildschirmmaske gewechselt.

## Patentansprüche

1. Benutzerführung bei der optischen Inspektion und Vermessung von beschichteten und unbeschichteten Substraten mit einem optischen Meßsystem **gekennzeichnet durch** einen integrierten Rezept- und Daten-Browser mit sortierbaren Merkmalen.

2. Benutzerführung nach Anspruch 1 **gekennzeichnet durch** einen Verzeichnisbaum, in dem Verzeichnisse mit Daten für den Rezept- und Daten-Browser geöffnet oder erstellt werden und der zugleich mit dem integrierten Rezept- und Daten-Browser auf dem Bildschirm eines Computers erscheint und zugleich bedienbar ist.

3. Benutzerführung nach Anspruch 1 oder 2, **dadurch gekennzeichnet, dass** eine interaktive, speicherbare Research-Messung während einer Rezepterstellung mit der Übernahme von aktuellen Einstellwerten in das aktuelle Rezept durchführbar ist.

4. Benutzerführung nach einem der vorhergehenden Ansprüche **gekennzeichnet durch** einen Job-Commander zur detaillierten Eingabe von Parametern.

5. Benutzerführung nach einem der vorhergehenden Ansprüche **gekennzeichnet durch** einen Data-Commander zur detaillierten Darstellung von Inspektions- und Meßergebnissen.

6. Benutzerführung nach einem der vorhergehenden Ansprüche, **dadurch gekennzeichnet, dass** das optische Meßsystem ein Schichtanalysesystem ist.

7. Benutzerführung nach Anspruch 6, **dadurch gekennzeichnet, dass** das Schichtanalysesystem ein Spektralphotometer und ein Spektralellipsometer enthält.

8. Benutzerführung nach Anspruch 7, **gekennzeichnet durch** die Kombination zweier verschiedener Messarten bei der Schichtanalyse.

9. Software, gespeichert auf einem Datenträger, zur Benutzerführung bei der optischen Inspektion und Vermessung von beschichteten und unbeschichteten Substraten mit einem optischen Meßsystem **gekennzeichnet durch** einen integrierten Rezept- und Daten-Browser mit sortierbaren Merkmalen.

10. Optisches System zur Inspektion oder Vermessung von beschichteten und unbeschichteten Substraten **gekennzeichnet durch** einen Computerbildschirm, der einen integrierten Rezept- und Daten-Browser mit sortierbaren Merkmalen zeigt.
